(19) **Europäisches Patentamt**
**European Patent Office**
**Office européen des brevets**

(11) **EP 3 771 351 B1**

(12) **EUROPEAN PATENT SPECIFICATION**

(45) Date of publication and mention
of the grant of the patent:
**07.09.2022 Bulletin 2022/36**

(21) Application number: **20188650.4**

(22) Date of filing: **30.07.2020**

(51) International Patent Classification (IPC):
***A24F 40/00*** *(2020.01)* ***H05B 1/02*** *(2006.01)*

(52) Cooperative Patent Classification (CPC):
**H05B 1/0227; A24F 40/53;** A24F 40/10

(54) **ELECTRONIC ATOMIZATION DEVICES, METHODS FOR HEATING CONTROL, AND COMPUTER PROGRAM PRODUCTS**

ELEKTRONISCHE ZERSTÄUBUNGSVORRICHTUNGEN, VERFAHREN ZUR HEIZUNGSSTEUERUNG UND COMPUTERPROGRAMMPRODUKTE

DISPOSITIFS D'ATOMISATION ÉLECTRONIQUE, PROCÉDÉS DE COMMANDE DE CHAUFFAGE ET PRODUITS DE PROGRAMME INFORMATIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.07.2019 CN 201910696244**

(43) Date of publication of application:
**03.02.2021 Bulletin 2021/05**

(73) Proprietor: **Shenzhen Smoore Technology Limited Shenzhen Guangdong 518102 (CN)**

(72) Inventors:
• **SUN, Changwen**
**Shenzhen, Guangdong 518102 (CN)**
• **FANG, Weiming**
**Shenzhen, Guangdong 518102 (CN)**
• **DAI, Zhenggen**
**Shenzhen, Guangdong 518102 (CN)**

• **ZHOU, Jun**
**Shenzhen, Guangdong 518102 (CN)**
• **WANG, Xinyu**
**Shenzhen, Guangdong 518102 (CN)**
• **ZHANG, Xin**
**Shenzhen, Guangdong 518102 (CN)**
• **DONG, Wenjie**
**Shenzhen, Guangdong 518102 (CN)**
• **KANG, Lijun**
**Shenzhen, Guangdong 518102 (CN)**

(74) Representative: **Manitz Finsterwald Patent- und Rechtsanwaltspartnerschaft mbB Martin-Greif-Strasse 1 80336 München (DE)**

(56) References cited:
**WO-A1-2016/112541 WO-A1-2017/185355 CN-A- 108 363 432 CN-A- 109 007 985 US-A1- 2014 020 693**

**Description**

RELATED APPLICATIONS

This application claims priority to Chinese Patent Application No. 2019106962440, filed on July 30, 2019, in the China National Intellectual Property Administration.

TECHNICAL FIELD

The present disclosure relates to the technical field of electronic atomization devices, and more particularly, to electronic atomization devices, methods for heating control, and computer program products.

BACKGROUND

An electronic cigarette is also known as a virtual cigarette or an electronic atomization device. As a substitute for cigarette, the electronic cigarette has a similar appearance and taste to those of a conventional cigarette, while it does not contain tar suspended particles and other harmful ingredients.

An electronic atomization device generally includes a liquid storage unit, an atomization unit, and a battery unit. In the existing electronic atomization device, the purpose of preventing dry burning is mainly to prevent the generation of harmful substances and burnt smell. Because once the burnt smell is generated, some unhealthy substances will be produced, thereby endangering human health. The main reason for the generation of harmful gas and burnt smell during the heating process of the electronic atomization device is that the liquid continues to be heated after being exhausted, and the liquid flow in the liquid guiding element in the atomization unit is poor, resulting in the liquid in the liquid storage unit not being smooth guided to the heating element of the atomization unit and the temperature in the heating process is so high that harmful substances is produce. US 2014/020693 A1 provides an electrically operated aerosol generating system for receiving an aerosol-forming substrate. WO 2017/185355 A1 discloses a method for detecting whether a cigarette liquid in an electronic cigarette is consumed up. WO 2016/112541 A1 discloses an electronic cigarette for automatically controlling atomising power and a method for same. CN 108 363 432 A discloses a temperature control method and system of an aerial fog generating device. CN 109 007 985 A discloses a hybrid electronic cigarette, wherein the mouth feel of the smoke is moist, the taste of the smoke is similar to the smoke generated by combustion of a prior cigarette, and the smoke has low tar amount.

SUMMARY

Accordingly, it is necessary to provide an electronic atomization device, a method for heating control, and a storage medium, which can prevent dry burning in view of the above technical problems. The present invention is set out in the appended claims.

According to an aspect of the present disclosure, an electronic atomization device is provided, which includes an atomization unit and a control unit.

The atomization unit is configured to heat liquid in the electronic atomization device to atomize the liquid. The control unit comprises a microprocessor configured to: send a PWM control signal to the atomization unit, and the PWM control signal is configured to control the atomization unit to heat at a constant temperature kept to a target temperature; wherein the control unit is configured to: calculate an effective output power of the atomization unit; determine whether liquid content of the atomization unit is abnormal according to the effective output power; and control the atomization unit to output a reduced power or stop heating, when it is determined that the liquid content of the atomization unit is abnormal; and wherein each PWM cycle of the PWM control signal comprises a plurality of power-on phases and power-off phases; the control unit comprises a sampling circuit configured to acquire a heating resistance of the atomization unit in each power-off phase during one preset time cycle; and send the heating resistance to the microprocessor; and the microprocessor is configured to: acquire an output voltage of a power supply of the electronic atomization device in each power-on phase during the preset time cycle, and acquire a duty ratio of the PWM cycle corresponding to a respective output voltage and heating resistance during the preset time cycle; calculate a plurality of effective output powers during the preset time cycle according to each output voltage, each heating resistance and the corresponding duty ratio; and control the atomization unit to output the reduced power or stop heating, if each effective output power is less than a preset power threshold.

In an embodiment, sampling circuit is configured to acquire a real-time resistance of the atomization unit and send the real-time resistance to the microprocessor. The microprocessor is further configured to determine a real-time temperature of the atomization unit according to the real-time resistance, and adjust the PWM control signal according to a difference between the real-time temperature and the target temperature to adjust the real-time temperature of the atomization unit to obtain the target temperature.

In an embodiment, the electronic atomization device further includes a prompt unit configured to provide a user prompt adapted to prompt a user the atomization unit has the abnormal liquid content.

The microprocessor is further configured to generate the user prompt in response to determining the atomization unit has the abnormal liquid content.

In an embodiment, the prompt unit includes at least one of a display screen and a voice prompter.

In an embodiment, the sampling circuit includes: a MOS transistor Q1, a diode D1, a resistor R1 and a resistor R2.

The MOS transistor Q1 has a gate electrically connected to an ADC sampling terminal of the microprocessor, a drain electrically connected to a first end of the resistor R1, and a source electrically connected to a power supply. The second end of the resistor R1 is electrically connected to a cathode of the diode D1, and an anode of the diode D1 is grounded. The cathode of the diode D1 is further electrically connected to an output terminal of the microprocessor, the output terminal of the microprocessor is further electrically connected to a first end of the atomization unit, and a second end of the atomization unit is grounded. The resistor R2 has a first end electrically connected to the gate of the MOS transistor Q1, and a second end electrically connected to the source of the MOS transistor Q1.

According to another aspect of the present disclosure, a method for heating control applied to the electronic atomization device is also provided. The electronic atomization device includes an atomization unit configured to heat liquid in the electronic atomization device to atomize the liquid, and a control unit. The control unit executes the heating control method, and the heating control method includes: sending a PWM control signal to the atomization unit, wherein the PWM control signal is configured to control the atomization unit to heat at a constant temperature kept to a target temperature; calculating an effective output power of the atomization unit; determining whether liquid content of the atomization unit is abnormal according to the effective output power; and controlling the atomization unit to output a reduced power or stop heating when it is determined that the liquid content of the atomization unit is abnormal.

Each PWM cycle of the PWM control signal includes a plurality of power-on phases and power-off phases, and the calculating the effective power of the atomization unit comprises:

acquiring an output voltage of a power supply of the electronic atomization device in each power-on phase during one preset time cycle; acquiring a heating resistance of the atomization unit in each power-off phase during the preset time cycle; acquiring a duty ratio of the PWM cycle corresponding to each output voltage and heating resistance during the time period; and calculating a plurality of effective output powers during the time period according to each output voltage, each heating resistance and a corresponding duty ratio.

In an embodiment, the determining whether the liquid content of the atomization unit is abnormal according to the effective output power includes: determining the liquid content of the atomization unit is abnormal if each effective output power is less than a preset power threshold.

In an embodiment, the electronic atomization device further includes a prompt unit, the method further includes: generating prompt information adapted to prompt the user that the liquid content of the atomization unit is abnormal, if each effective output power is less than the power threshold; and sending the prompt information to the prompt unit for presentation.

In an embodiment, the controlling the atomization unit to heat at a constant temperature kept to the target temperature includes: acquiring a real-time temperature of the atomization unit; and adjusting the real-time temperature of the atomization unit according to the target temperature.

In an embodiment, the adjusting the real-time temperature of the atomization unit according to a target temperature includes: acquiring an initial resistance and an initial temperature of the atomization unit in an unheated state; calculating a target resistance of the atomization unit when heating to the target temperature according to the initial resistance, the initial temperature, the temperature coefficient of resistance and the preset target temperature of the atomization unit; acquiring a heating resistance through an ADC sampling method; and adjusting the PWM control signal by means of a PID algorithm to adjust the real-time temperature of the atomization unit, when an absolute value of a difference between the heating resistance and the target resistance is greater than a lower limit of a preset difference range and less than an upper limit of the difference range.

In an embodiment, the adjusting the real-time temperature of the atomization unit according to the target temperature includes: controlling the atomization unit to heat with the maximum output power, when the absolute value of the difference between the heating resistance and the target resistance is less than the lower limit of the difference range.

In an embodiment, the acquiring an initial resistance of the atomization unit in an unheated state includes: sampling the resistance of the atomization unit at a preset sampling frequency, in respond to identifying loading of the cartridge; comparing the acquired resistances; determining the resistances as the initial resistance of the atomization unit in the unheated state, if the resistances are all equal; updating the initial resistance record; and acquiring the initial resistance determined in the last time from the initial resistance record as the initial resistance of the atomization unit in the unheated state, if the acquired resistances change with the acquisition time.

According to another aspect of the present disclosure, a computer program product applied to an electronic atomization device is also provided. The computer program product includes: a machine readable medium; and program instructions contained in the machine readable medium, the program instructions specifying a method for heating control according to the above aspect.

## BRIEF DESCRIPTION OF THE DRAWINGS

FIG. 1 is a schematic diagram illustrating an electronic atomization device according to an embodiment.

FIG. 2 is a schematic diagram illustrating an electronic atomization device according to another embodiment.

FIG. 3 is a schematic diagram illustrating an electronic atomization device according to a further embodiment.

FIG. 4 is a circuit structural diagram illustrating a sampling circuit according to an embodiment.

FIG. 5 is a schematic flow diagram illustrating method for heating control according to an embodiment.

FIG. 6 is a structural block diagram illustrating a device for heating control according to an embodiment.

## DETAILED DESCRIPTION OF THE EMBODIMENTS

The Reference will be made to the accompanying drawings and embodiments to describe the present disclosure in detail, so that the objects, technical solutions and advantages of the present disclosure may be more apparent and understandable. It should be understood that the specific embodiments described herein are only used to explain the present disclosure and not intended to limit the present disclosure.

Unless otherwise defined, all terms herein, including technical and scientific terms, shall have the same meaning as commonly accepted by a person skilled in the art to which this disclosure belongs. The terms used in the specification of the invention herein are for the purpose of describing specific embodiments only and are not intended to limit the present disclosure.

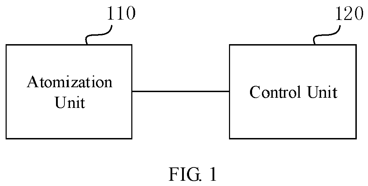

In an embodiment, as shown in FIG. 1, an electronic atomization device is provided, which includes an atomization unit 110 and a control unit 120.

The atomization unit 110 is configured to heat liquid in a cartridge to atomize the liquid.

The control unit 120 is configured to: control the atomization unit 110 to heat with a constant output of a preset power for a preset period of time in response to receiving a start-up instruction to start, and determine whether the atomization unit 110 has normal liquid content according to a variation in a resistance of the atomization unit 110 after heating; control the atomization unit 110 to heat to a preset target temperature in response to receiving a suction and heating instruction, if the atomization unit has the normal liquid content; detect whether the atomization unit 110 has the normal liquid content according to a preset time cycle; and control the atomization unit 110 to output a reduced power or stop heating, if the atomization unit has abnormal liquid content.

The constant output of the preset power means that the atomizing unit 110 performs heating while maintaining its output power constant. The preset period of time is a relative short period of time. For example, the atomizing unit 110 performs heating at an output power of 10W for 50 ms. In an embodiment, a higher or lower output power can also be used, and the output time can also be adjusted as necessary. The atomization unit 110 may perform preheating for a relative short time, so that if the liquid content is lower than a normal content, due to the relative short time for heating and thus the relative short duration for dry burning, it is not easy to damage the atomization unit 110 of the electronic atomization device, and can avoid harmful gas and burnt smell caused by long-term dry burning. If the liquid content is normal, since this heating is only to detect the liquid content of the atomization unit, heating for the relative short time can reduce the consumption of the liquid. In an embodiment, the preset period of time is less than 150 ms. In another embodiment, the preset period of time may be selected form a range of 50 ms to 100 ms. A shorter time may be selected so that a detection result can be output within the shorter time and the user can have a better experience.

The resistance of the atomization unit 110 changes with the temperature. A variation in the resistance may be calculated according to an initial resistance of the atomization unit 110 before heating and the changed resistance of the atomization unit 110 after heating for the preset period of time. According to the law of conservation of energy, it can be known that when the output power of the atomization unit 110 is constant, the output energy generated within a preset period of time is fixed. A part of the energy is absorbed by the liquid, while another part of the energy is absorbed by the atomization unit 110 itself. When the liquid is sufficient, the more energy, i.e., heat, absorbed by the liquid, the less energy absorbed by the atomization unit 110 itself, and when the liquid is insufficient, the energy absorbed by the liquid decreases, and the energy absorbed by the atomization unit 110 itself increases. Within the preset period of time, the more energy absorbed by the atomization unit 110, the greater the temperature change and the greater the variation in the resistance of the atomization unit is. Therefore, whether the current liquid content of the atomization unit is normal can be determined by comparing the variation in the resistance with a preset threshold.

The reason for the abnormal liquid content may include low liquid content or no liquid. Since the atomization unit generally includes a heating element and a liquid guiding element, the abnormal liquid content may be caused by poor flow of the liquid in the liquid guiding element in some embodiments. When the liquid in the liquid guiding element flows poorly, for example, flows during traffic jam, no liquid is heated by the heating element, so that the temperature of the heating element itself will become too high and produce burnt smell, and even the liquid guiding element will be burnt due to overheating of the heating element. The heating element may be a ceramic or metal heating element. The liquid guiding element may include a porous carrier material. The parameters related to the resistance of the atomization unit mentioned in the present disclosure, such as the initial resistance and the preheating resistance, are essentially the resistance of the heating element.

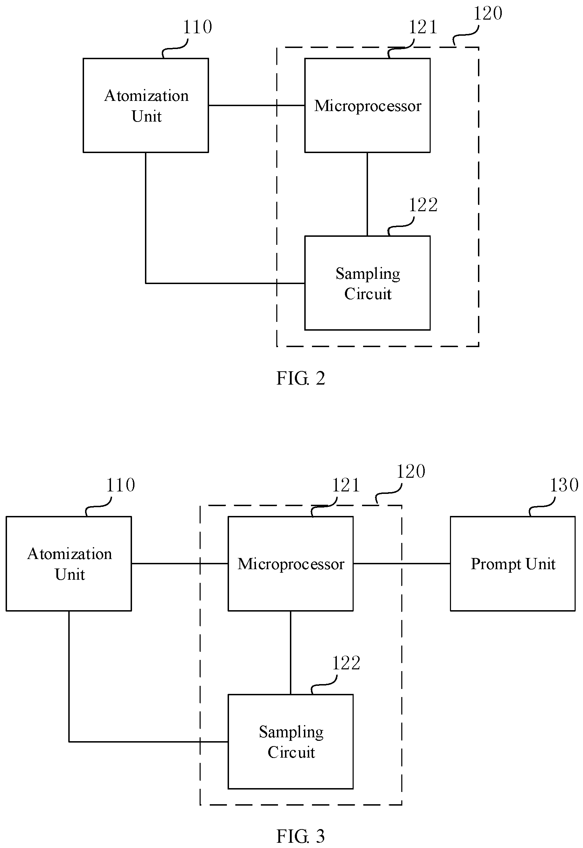

In an embodiment, as shown in FIG. 2, the control unit 120 includes a microprocessor 121 and a sampling circuit 122.

The microprocessor 121 is configured to control the sampling circuit 122 to acquire an initial resistance of the atomization unit 110 in response to receiving a start-up instruction to start.

The microprocessor 121 is further configured to: control the atomization unit 110 to heat with the constant output of the preset power for the preset period of time; control the sampling circuit 122 to acquire a preheating resistance of the atomization unit 110 after heating for the preset period of time; calculate the variation in the resistance of the atomization unit 110 according to the initial resistance and the preheating resistance; and control the atomization unit 110 to heat to the preset target temperature in response to receiving the suction and heating instruction, if the variation in the resistance is greater than a preset resistance threshold.

The initial resistance refers to a resistance when there is no heating and the temperature of the atomization unit 110 is equal to a room temperature. The pre-heating resistance is the resistance of the atomization unit 110 changing with the temperature after heating for the preset period of time.

In an embodiment, the preset power constantly output by the atomization unit 110 is greater than or equal to the lowest power that the electronic atomization device can output at the lowest voltage, and less than or equal to the highest power that the electronic atomization device can output at the highest voltage.

The determination to the variation in the resistance can be applied to full power. Even if the heating time is very short and the output power is low, the determination can be made. Even if the electric quantity of the electronic atomization device is low, the detection can be made even if a low output power can be generated.

In an embodiment, the preset power constantly output by the atomization unit 110 is less than the lowest atomization power required for the electronic atomization device to output in order to generate smoke.

The determination to the variation in the resistance can be made without heating to a temperature that can atomize the liquid, so as to avoid the problem of dry burning at a high temperature. If the liquid content of the electronic atomization device is normal, the consumption of the liquid during detection can also be reduced.

In an embodiment, the microprocessor 121 is further configured to send a PWM control signal to the atomization unit 110. The PWM control signal is configured to control the atomization unit 110 to heat at a constant temperature kept to the target temperature.

The sampling circuit 122 is further configured to acquire a real-time resistance of the atomization unit 110 and send the real-time resistance to the microprocessor 121.

The microprocessor 121 is further configured to determine a real-time temperature of the atomization unit 110 according to the real-time resistance, and adjust the PWM control signal according to the target temperature to adjust the real-time temperature of the atomization unit 110.

Pulse-width modulation (PWM) technology is an analog control method, which modulate a bias applied to a base of a transistor or a gate of a MOS transistor Q1 according to the change of the corresponding load, to achieve the change of the conduction time of the transistor or the MOS transistor Q1, so as to achieve the change of the output of the stabilized switching power supply. In this way, the output voltage of the power supply can be kept constant when the working conditions change, and it is a very effective technology for controlling the analog circuit using the digital signal of the control unit. Heating at a constant temperature refers to maintaining the temperature of the atomization unit 110 at the target temperature to heat the liquid, and heating at the constant temperature can ensure the taste of smoke and the uniform amount of smoke.

In order to keep the atomization unit 110 to heat at the constant temperature, it is necessary to acquire its real-time temperature to adjust the real-time temperature according to the difference between the real-time temperature and the target temperature. The real-time temperature of the atomization unit 110 is acquired. If the real-time temperature is not equal to the target temperature, it needs to be adjusted. If it is higher than the target temperature, it needs to be adjusted down. If it is lower than the target temperature, it needs to be adjusted up. Changing the PWM control signal is changing the control of the width of the pulse signal output, and adjusting the time of turning on and turning off of the atomization unit 110, thereby changing the voltage and achieving the purpose of changing the temperature. According to the initial resistance $R_0$, the initial temperature $T_0$, the temperature coefficient of resistance $K_{tcr}$ and the preset target temperature $T_{aim}$ of the atomization unit 110, the target resistance $R_{aim}$ of the atomization unit 110 heated to the target temperature is calculated as below:

$$R_{aim} = R_0 + K_{tcr} \times (T_{aim} - T_0).$$

The microprocessor 121 may be an MCU or a PLC, both of which have the function of ADC sampling, and may cooperate with the sampling circuit 122 to acquire the heating resistance. The heating resistance refers to the resistance of the atomization unit 110 under heating control at the constant temperature. In the control process, the control according to the ratio (P), the integral (I) and the derivative (D) of the deviation is called PID control algorithm. Specifically, any one of PID control algorithms such as incremental PID algorithm, positional PID algorithm and differential forward PID can be used. In an embodiment, since the amount of smoke generated is required during the heating process of the electronic atomization device, each heating time generally does not exceed 5 seconds, and it is necessary to quickly raise the temperature to the target temperature and control it stable, the incremental PID algorithm is used. In an embodiment, before the absolute value of the difference between the heating resistance and the target resistance reaches the lower limit of the difference range, the heating is performed with the maximum output power, which can make the temperature of the atomization unit 110 reach the atomizing temperature point to atomize the liquid as soon as possible.

In order to ensure that the acquired initial resistance is the resistance of the atomization unit 110 at the room temperature, the resistance is sampled when the cartridge is loaded, and then the sampled resistance is determined. Performing sampling at a preset sampling frequency refers to sampling once every t time according to a preset time interval t. In an embodiment, the resistance is sampled for a number of times corresponding to a preset number of sampling times, to acquire a specific number of resistances of the atomization unit 110 with the specific number being equal to the sampling times. The acquired resistances are compared. If the plurality of acquired resistances of the atomization unit 110 are all equal, it means that the temperature of the atomization unit 110 has not changed, and it is determined that the atomization unit 110 is currently in an unheated state, so the resistance can be used as an initial resistance. The initial resistance record refers to the record of the initial resistance of the atomization unit 110 determined by the acquisition in an unheated state. If the plurality of acquired resistances of the atomization unit 110 change with the acquisition time (because there is no heating currently, the resistances are generally reduced), it means that the atomization unit 110 is currently not at the room temperature, but in a state after being heated, so the temperature will decrease with time, resulting in a reduction in resistance. The resistance acquired at this time cannot be used as the initial resistance. In order to quickly determine the initial resistance, the initial resistance determined in the last time may be directly acquired from the initial resistance record and used as the initial resistance of the current atomization unit 110.

In an embodiment, each PWM cycle of the PWM control signal includes a plurality of power-on phases and power-off phases.

The sampling circuit 122 is further configured to acquire a heating resistance of the atomization unit 110 in each power-off phase during one preset time cycle.

The microprocessor 121 is further configured to: acquire an output voltage of the power supply of the electronic atomization device in each power-on phase during one preset time cycle, and acquire a duty ratio of the PWM cycle corresponding to the corresponding to a respective output voltage and heating resistance during the preset time cycle; calculate a plurality of effective output powers during the preset time cycle according to each output voltage, each heating resistance and the corresponding duty ratio; and control the atomization unit 110 to stop heating, if each effective output power is less than a preset power threshold.

During the preset time cycle from t1 to t2, the output voltage V of the power supply of the electronic atomization device is acquired when each switching transistor is turned on under the control of the PWM control signal and the atomization unit 110 is powered on. Since the PWM control signal may change during one time period, it is necessary to acquire the output voltage V of the power supply of the electronic atomization device in each power-on phase. During the time period from t1 to t2 corresponding to the acquired output voltage V of the power supply, the heating resistance R of the atomization unit 110 is acquired when each switching transistor is turned off under the control of the PWM control signal and the atomization unit 110 is powered off. Since the PWM control signal may change during one time period, it is necessary to acquire the heating resistance of the atomization unit 110 in each power-off phase. Since the PWM control signal may change during one time period, the duty ratio *Duty* corresponding to the PWM control signal during the time period needs to be acquired. A plurality of effective output powers $P_{rms}$ during the time period are calculated according to each output voltage V, each heating resistance R and a corresponding duty ratio *Duty* as below:

$$P_{rms} = \frac{V^2}{R} \times Duty \; .$$

According to the law of conservation of energy, it can be known that a part of the heat generated by the atomization unit 110 is absorbed by itself to cause its own temperature to rise, and another part of the heat is absorbed by the liquid, so that the liquid is atomized. When the heating is at the constant temperature and the liquid content is normal, the liquid can absorb the heat stably, a heat balance can be reached, and the effective output power can be stabilized at a certain value. When the liquid content decreases, the energy output of the atomization unit 110 decrease accordingly. If each effective output power during the time period from t1 to t2 is less than the preset power threshold, it means that the liquid content is lower than the normal liquid content, and the atomization unit 110 needs to be controlled to stop heating to avoid dry burning. It is ensured that the user can control the atomization unit 110 to stop heating once the liquid content is insufficient during the smoking process via regular inspection, so as to avoid burnt smell or even harmful gas being sucked by the user due to dry burning.

In an embodiment, as shown in FIG. 3, the electronic atomization device further includes an prompt unit 130.

The microprocessor 121 is further configured to generate a user prompt in response to determining the liquid content of the atomization unit is lower than the normal liquid content, and send the user indication to the indication unit 130. The user prompt is adapted to prompt the user that the liquid content of the atomization unit is lower than the normal liquid content.

The prompt unit 130 is configured to provide the user prompt.

When the user liquid content is lower than an operable normal liquid content, there may be still a certain liquid content, but since the liquid content is low, it may cause dry burning; or there may be no liquid content. Therefore, when the liquid content is lower than the operable normal liquid content, it is required to prompt the user so that the user can add the liquid or replace the cartridge with enough liquid in time. In some cases, the inverted electronic atomization device may also lead to a situation where the liquid content is detected to be lower than the operable normal liquid content, and there is a safety hazard when the electronic atomization device is inverted during use. After prompting the user with the prompting information, the user may check the electronic atomization device to avoid potential safety hazards. The method of prompting may include voice prompting, text prompting, vibration prompting, or any other methods, or a combination thereof, and the type of the prompting information may be determined according to the method adopted by a specific electronic atomization device.

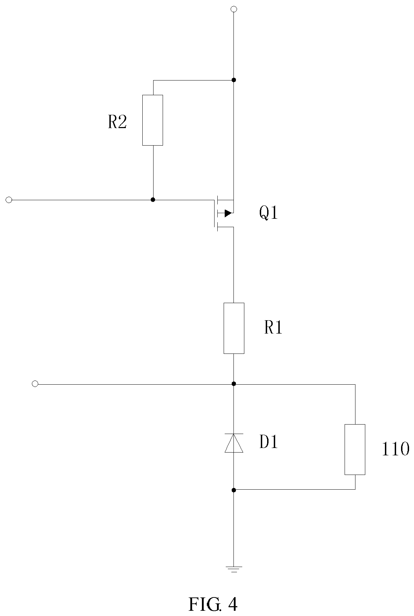

In an embodiment, as shown in FIG. 4, the sampling circuit 122 includes a MOS transistor Q1, a diode D1, a resistor R1 and a resistor R2;

The MOS transistor Q1 has a gate electrically connected to the ADC sampling terminal of the microprocessor 121, a drain electrically connected to the first end of the resistor R1, and a source electrically connected to the power supply.

The second end of the resistor R1 is electrically connected to a cathode of the diode D1, and an anode of the diode D1 is grounded.

The cathode of the diode D1 is further electrically connected to an output terminal of the microprocessor 121, the output terminal of the microprocessor 121 is further electrically connected to a first end of the atomization unit 110, and a second end of the atomization unit 110 is grounded.

The resistor R2 has a first end electrically connected to the gate of the MOS transistor Q1, and a second end electrically connected to the source of the MOS transistor Q1.

In an embodiment, the prompt unit 130 includes at least one of a display screen and a voice indicator.

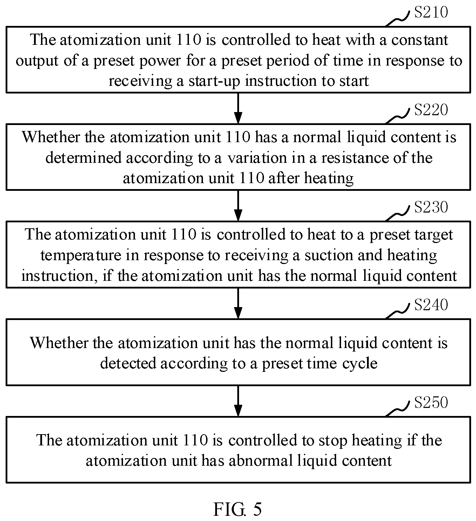

In one embodiment, as shown in FIG. 5, a method for heating control is provided, which includes the following steps.

In step 210, the atomization unit 110 is controlled to heat with a constant output of a preset power for a preset period of time in response to receiving a start-up instruction to start.

In step 220, whether the atomization unit 110 has a normal liquid content is determined according to a variation in a resistance of the atomization unit 110 after heating.

In step 220, the atomization unit 110 is controlled to heat to a preset target temperature in response to receiving a suction and heating instruction, if the atomization unit has the normal liquid content.

In step 240, whether the atomization unit has the normal liquid content is detected according to a preset time cycle.

In step 250, the atomization unit 110 is controlled to stop heating if the atomization unit has abnormal liquid content.

In an embodiment, the method for heating control further includes: sending a PWM control signal to the atomization unit 110, the PWM control signal configured to control the atomization unit 110 to heat at a constant temperature kept to a preset target temperature, each PWM cycle of the PWM control signal including a plurality of power-on phases and power-off phases; acquiring an output voltage of the power supply of the electronic atomization device in each power-on phase during a preset time cycle; acquiring a heating resistance of the atomization unit 110 in each power-off phase during a preset time cycle; acquiring a duty ratio of the PWM cycle corresponding to a respective output voltage and heating resistance during the time period; calculating a plurality of effective output powers during the time period according to each output voltage V, each heating resistance R and a corresponding duty ratio; and controlling the atomization unit 110 to stop heating, if each effective output power is less than a preset power threshold.

In an embodiment, the electronic atomization device further includes a prompt unit 130. The method further includes: generating prompt information adapted to prompt the user that the liquid content of the atomization unit is abnormal, if each effective output power is less than the power threshold; and sending the prompt information to the prompt unit 130 for presentation.

In an embodiment, the step of controlling the atomization unit 110 to heat at the constant temperature includes: acquiring a real-time temperature of the atomization unit 110; and adjusting the real-time temperature of the atomization unit 110 according to a target temperature.

In an embodiment, the step of adjusting the real-time temperature of the atomization unit 110 according to the target temperature includes: acquiring an initial resistance and an initial temperature of the atomization unit 110 in an unheated state; calculating the target resistance of the atomization unit 110 when heating to the target temperature according to the initial resistance, the initial temperature, the temperature coefficient of resistance and the preset target temperature of the atomization unit 110; acquiring a heating resistance through an ADC sampling method; and adjusting the PWM control signal by means of the PID algorithm to adjust the temperature of the atomization unit 110, when the absolute value of the difference between the heating resistance and the target resistance is greater than the lower limit of the preset difference range and less than the upper limit of the difference range.

In an embodiment, the step of adjusting the real-time temperature of the atomization unit 110 according to the target temperature further includes: controlling the atomization unit 110 to heat with the maximum output power, when the absolute value of the difference between the heating resistance and the target resistance is less than the lower limit of the difference range.

In an embodiment, the step of acquiring the initial resistance of the atomization unit 110 in an unheated state includes: sampling the resistance of the atomization unit 110 at a preset sampling frequency, in respond to identifying loading of the cartridge; comparing the acquired resistances; determining the resistances as the initial resistance of the atomization unit 110 in the unheated state, if the resistances are all equal; updating the initial resistance record; and acquiring the initial resistance determined in the last time from the initial resistance record as the initial resistance of the atomization unit 110 in the unheated state, if the acquired resistances change with the acquisition time.

Details of the heating control method may refer to the above description of the electronic atomization device, which will not be repeated here. It should be understood that although all steps in the flow diagram of FIG. 5 are sequentially displayed as indicated by the arrows, these steps are not necessarily performed in the order indicated by the arrows. Unless explicitly stated herein, the performing order of the steps is not be limited strictly, and the steps may be performed in other orders. Moreover, at least part of the steps in FIG. 5 may include a plurality of sub-steps or phases, which are not necessary to be performed simultaneously, but may be performed at different times, and for the performing order thereof, it is not necessary to be performed sequentially, but may be performed by turns or alternately with other steps or sub-steps of other steps or at least part of the phases.

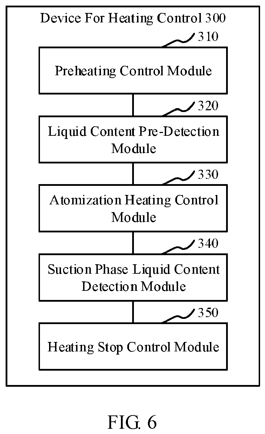

In an embodiment, as shown in FIG. 6, a device for heating control 300 is provided. The device includes a number of computing modules, to be described hereinafter. Each such module is understood to be a distinct process, processor module, or code module, residing on one or more computing devices. The modules illustrated in FIG. 6 include: a preheating control module 310, an liquid content pre-detection module 320, an atomization heating control module 330, a suction phase liquid content detection module 340 and a heating stop control module 350.

The preheating control module 310 is configured to control the atomization unit 110 to heat with a constant output of a preset power for a preset period of time in response to receiving the start-up instruction to start.

The liquid content pre-detecting module 320 is configured to determine whether the atomization unit 110 has normal liquid content according to a variation in a resistance of the atomization unit 110 after heating.

The atomization heating control module 330 is configured to control the atomization unit 110 to heat to a preset target temperature in response to receiving a suction and heating instruction, when the atomization unit 110 has the normal liquid content.

The suction phase liquid content detecting module 340 is configured to detect whether the atomization unit 110 has the normal liquid content according to a preset time cycle.

The heating stop control module 340 is configured to control the atomization unit 110 to output a reduced power or stop heating, if the atomization unit 110 has abnormal liquid content.

Details of the device for heating control 300 may refer to the above description of the method for heating control, which will not be repeated here. Each of the above modules in the device for heating control 300 may be implemented in whole or in part through software, hardware or a combination thereof. When implemented through hardware, the above modules may be embedded in or independent of a processor in the computing device. When implemented through software, the above modules may stored on a computer-readable medium of the computing device or can be transmitted as one or more instruction or code on the computer-readable storage medium, so that the processor can invoke and execute the operations corresponding to the above modules. Additionally, each functional module can be integrated in one processing unit or can be separated physically, or two or more modules can be integrated into one module. The integrated modules described above can be implemented in the form of hardware or software.

In an embodiment, a computer readable storage medium is provided. A computer program executable by a processor is stored on the computer readable storage medium. When the computer program is executed by the processor, the processor is caused to: control the atomization unit 110 to heat with a constant output of a preset power for a preset period of time in response to receiving a start-up instruction to start; determine whether the atomization unit 110 has normal liquid content according to a variation in a resistance of the atomization unit 110 after heating; control the atomization unit 110 to heat to a preset target temperature in response to receiving the suction and heating instruction, if the atomization unit has the normal liquid content; detect whether the atomization unit has the normal liquid content according to a preset time cycle; and control the atomization unit 110 to output a reduced power or stop heating, if the atomization unit 110 has abnormal liquid content.

In an embodiment, when the computer program is executed by the processor, the processor is further caused to: send a PWM control signal to the atomization unit 110, the PWM control signal configured to control the atomization unit 110 to heat at a constant temperature kept to a preset target temperature, each PWM cycle of the PWM control signal including a plurality of power-on phases and power-off phases; acquire a output voltage of a power supply of the electronic atomization device in each power-on phase during one preset time cycle; acquire a heating resistance of the atomization unit 110 in each power-off phase during the preset time cycle; acquire a duty ratio of the PWM cycle corresponding to each output voltage and heating resistance during the time period; calculate a plurality of effective output powers during the time period according to each output voltage V, each heating resistance R and a corresponding duty ratio; and control the atomization unit 110 is to stop heating, if each effective output power is less than a preset power threshold.

In an embodiment, when the computer program is executed by the processor, the processor is further caused to: generate prompt information adapted to prompt the user that the liquid content of the atomization unit is abnormal, if each effective output power is less than the power threshold; and send the prompt information to the prompt unit 130 for presentation.

In an embodiment, when the computer program is executed by the processor, the processor is further caused to: acquire a real-time temperature of the atomization unit 110; and adjust the real-time temperature of the atomization unit 110 according to a target temperature.

In an embodiment, when the computer program is executed by the processor, the processor is further caused to: acquire an initial resistance and an initial temperature of the atomization unit 110 in an unheated state; calculate the target resistance of the atomization unit 110 when heating to the target temperature according to the initial resistance, the initial temperature, the temperature coefficient of resistance and the preset target temperature of the atomization unit 110; acquire a heating resistance through an ADC sampling method; adjust the PWM control signal by means of the PID algorithm to adjust the temperature of the atomization unit 110, when the absolute value of the difference between the heating resistance and the target resistance is greater than the lower limit of the preset difference range and less than the upper limit of the difference range.

In an embodiment, when the computer program is executed by the processor, the processor is further caused to: control the atomization unit 110 to heat with the maximum output power, when the absolute value of the difference between the heating resistance and the target resistance is less than the lower limit of the difference range.

In an embodiment, when the computer program is executed by the processor, the processor is further caused to: sample the resistance of the atomization unit 110 at a preset sampling frequency, in respond to identifying loading of the cartridge; comparing the acquired resistances; determine the resistances as the initial resistance of the atomization unit 110 in the unheated state, if the resistances are all equal; update the initial resistance record; and acquire the initial resistance determined in the last time from the initial resistance record as the initial resistance of the atomization unit 110 in the unheated state, if the acquired resistances change with the acquisition time.

A person skilled in the art should understand that the processes of the methods in the above embodiments can be, in full or in part, implemented by computer-readable instructions instructing underlying hardware. The computer-readable instructions can be stored in a computer-readable storage medium and executed by at least one processor in the computer operating system. The computer-readable instructions can include the processes in the embodiments of the various methods when it is being executed. Any references to memory, storage, databases, or other media used in various embodiments provided herein may include non-transitory and/or transitory memory. Non-transitory memory can include read only memory (ROM), programmable ROM (PROM), electrically programmable ROM (EPROM), electrically erasable programmable ROM (EEPROM), or flash memory. Transitory memory may include random access memory (RAM) or external high-speed cache memory. By way of illustration and not limitation, RAM is available in many forms such as static RAM (SRAM), dynamic RAM (DRAM), synchronous DRAM (SDRAM), double data rate SDRAM (DDR SDRAM), enhanced SDRAM (ESDRAM), synchronization chain Synchlink DRAM (SLDRAM), memory Bus (Rambus) direct RAM (RDRAM), direct memory bus dynamic RAM (DRDRAM), and memory bus dynamic RAM (RDRAM).

Those skilled in the art can apparently appreciate upon reading the disclosure of this application that the respective technical features involved in the respective embodiments can be combined arbitrarily between the respective embodiments as long as they have no collision with each other. Of course, the respective technical features mentioned in the same embodiment can also be combined arbitrarily as long as they have no collision with each other.

The aforementioned embodiments merely represent several embodiments of the present disclosure, and the description thereof is more specific and detailed, but it should not be construed as limiting the scope of the present disclosure. It should be noted that, several modifications and improvements may be made for those of ordinary skill in the art, without departing from the concept of the present disclosure, and these are all during the protection scope of the present disclosure. Therefore, the protection scope of the present disclosure shall be subject to the appended claims.

## Claims

1. An electronic atomization device, comprising:

   an atomization unit (110), configured to heat liquid in the electronic atomization device to atomize the liquid; and

a control unit (120) comprising a microprocessor (121) configured to send a PWM control signal to the atomization unit, and the PWM control signal is configured to control the atomization unit to heat at a constant temperature kept to a target temperature;

wherein the control unit (120) is configured to:

calculate an effective output power of the atomization unit;

determine whether liquid content of the atomization unit is abnormal according to the effective output power; and

control the atomization unit to output a reduced power or stop heating, when it is determined that the liquid content of the atomization unit is abnormal;

the electronic atomization device being **characterized in that**

each PWM cycle of the PWM control signal comprises a plurality of power-on phases and power-off phases;

the control unit (120) comprises a sampling circuit (122) configured to acquire a heating resistance of the atomization unit in each power-off phase during one preset time cycle; and send the heating resistance to the microprocessor (121); and

the microprocessor (121) is configured to:

acquire an output voltage of a power supply of the electronic atomization device in each power-on phase during the preset time cycle, and acquire a duty ratio of the PWM cycle corresponding to a respective output voltage and heating resistance during the preset time cycle;

calculate a plurality of effective output powers during the preset time cycle according to each output voltage, each heating resistance and the corresponding duty ratio; and

control the atomization unit to output the reduced power or stop heating, if each effective output power is less than a preset power threshold.

2. The electronic atomization device according to claim 1, wherein the sampling circuit (122) is configured to acquire a real-time resistance of the atomization unit (110) and send the real-time resistance to the microprocessor (121), and

wherein the microprocessor (121) is further configured to determine a real-time temperature of the atomization unit (110) according to the real-time resistance, and adjust the PWM control signal according to a difference between the real-time temperature and the target temperature to adjust the real-time temperature of the atomization unit to obtain the target temperature.

3. The electronic atomization device according to claim 2, further comprising a prompt unit (130) configured to provide a user prompt adapted to prompt a user the atomization unit (110) has the abnormal liquid content,

wherein the microprocessor (121) is further configured to generate the user prompt in response to determining the atomization unit (110) has the abnormal liquid content.

4. The electronic atomization device according to claim 3, wherein the prompt unit (130) comprises at least one of a display screen and a voice prompter.

5. The electronic atomization device according to claim 2, wherein:

the sampling circuit (122) comprises: a MOS transistor Q1, a diode D1, a resistor R1 and a resistor R2;

the MOS transistor Q1 has a gate electrically connected to an ADC sampling terminal of the microprocessor, a drain electrically connected to a first end of the resistor R1, and a source electrically connected to a power supply;

a second end of the resistor R1 is electrically connected to a cathode of the diode D1, and an anode of the diode D1 is grounded;

the cathode of the diode D1 is further electrically connected to an output terminal of the microprocessor, the output terminal of the microprocessor is further electrically connected to a first end of the atomization unit, and a second end of the atomization unit is grounded; and

the resistor R2 has a first end electrically connected to the gate of the MOS transistor Q1, and a second end electrically connected to the source of the MOS transistor Q1.

6. A method for heating control applied to an electronic atomization device, the electronic atomization device comprising an atomization unit (110) configured to heat liquid in the electronic atomization device to atomize the liquid, and a control unit (120), the control unit (120) executing the heating control method, the heating control method comprising:

sending a PWM control signal to the atomization unit, wherein the PWM control signal is configured to control the atomization unit to heat at a constant temperature kept to a target temperature;

calculating an effective output power of the atomization unit;

determining whether liquid content of the atomization unit is abnormal according to the effective output power; and

controlling the atomization unit to output a reduced power or stop heating when it is determined that the liquid content of the atomization unit is abnormal;

**characterized in that**

each PWM cycle of the PWM control signal comprises a plurality of power-on phases and power-off phases, and the calculating the effective output power of the atomization unit comprises:

acquiring an output voltage of a power supply of the electronic atomization device in each power-on phase during one preset time cycle;

acquiring a heating resistance of the atomization unit in each power-off phase during the preset time cycle;

acquiring a duty ratio of the PWM cycle corresponding to each output voltage and heating resistance during the time period; and

calculating a plurality of effective output powers during the time period according to each output voltage, each heating resistance and a corresponding duty ratio.

7. The method for heating control according to claim 6, wherein the determining whether the liquid content of the atomization unit is abnormal according to the effective output power comprises:

determining the liquid content of the atomization unit is abnormal if each effective output power is less than a preset power threshold.

8. The method for heating control according to claim 7, wherein the electronic atomization device further comprises a prompt unit, and the method further comprises:

generating prompt information adapted to prompt the user that the liquid content of the atomization unit is abnormal, if each effective output power is less than the power threshold; and

sending the prompt information to the prompt unit for presentation.

9. The method for heating control according to claim 6, wherein the controlling the atomization unit to heat at a constant temperature kept to the target temperature comprises:

acquiring a real-time temperature of the atomization unit; and

adjusting the real-time temperature of the atomization unit according to the target temperature.

10. The method for heating control according to claim 9, wherein the adjusting the real-time temperature of the atomization unit according to the target temperature comprises:

acquiring an initial resistance and an initial temperature of the atomization unit in an unheated state;

calculating a target resistance of the atomization unit when heating to the target temperature according to the initial resistance, the initial temperature, the temperature coefficient of resistance and the preset target temperature of the atomization unit;

acquiring a heating resistance through an ADC sampling method; and

adjusting the PWM control signal by means of a PID algorithm to adjust the real-time temperature of the atomization unit, when an absolute value of a difference between the heating resistance and the target resistance is greater than a lower limit of a preset difference range and less than an upper limit of the difference range.

11. The method for heating control according to claim 10, wherein the adjusting the real-time temperature of the atomization unit according to the target temperature comprises:

controlling the atomization unit to heat with the maximum output power, when the absolute value of the difference between the heating resistance and the target resistance is less than the lower limit of the difference range.

12. The method for heating control according to claim 10, wherein the acquiring an initial resistance of the atomization unit in an unheated state comprises:

sampling the resistance of the atomization unit at a preset sampling frequency, in respond to identifying loading of the cartridge;

comparing the acquired resistances;

determining the resistances as the initial resistance of the atomization unit in the unheated state, if the resistances are all equal; updating the initial resistance record; and

acquiring the initial resistance determined in the last time from the initial resistance record as the initial resistance of the atomization unit in the unheated state, if the acquired resistances change with the acquisition time.

13. A computer program product comprising: a machine readable medium; and

program instructions contained in the machine readable medium, the program instructions specifying a method for heating control according to any one of claims 6 to 12.

**Patentansprüche**

1. Elektronische Zerstäubungsvorrichtung, die umfasst:

   eine Zerstäubungseinheit (110), die so konfiguriert ist, dass sie Flüssigkeit in der elektronischen Zerstäubungsvorrichtung erhitzt, um die Flüssigkeit zu zerstäuben; und
   eine Steuereinheit (120), die einen Mikroprozessor (121) umfasst, der so konfiguriert ist, dass er ein PWM-Steuersignal an die Zerstäubungseinheit sendet, und wobei das PWM-Steuersignal so konfiguriert ist, dass es die Zerstäubungseinheit so steuert, dass sie bei einer konstanten Temperatur heizt, die auf einer Zieltemperatur gehalten wird;
   wobei die Steuereinheit (120) so konfiguriert ist, dass sie:

   eine effektive Ausgangsleistung der Zerstäubungseinheit berechnet;
   entsprechend der effektiven Ausgangsleistung bestimmt, ob ein Flüssigkeitsgehalt der Zerstäubungseinheit anormal ist; und
   die Zerstäubungseinheit so steuert, dass sie eine verringerte Leistung abgibt oder das Heizen stoppt, wenn festgestellt wird, dass der Flüssigkeitsgehalt der Zerstäubungseinheit anormal ist;
   wobei die elektronische Zerstäubungsvorrichtung **dadurch gekennzeichnet ist, dass**
   jeder PWM-Zyklus des PWM-Steuersignals eine Vielzahl von Einschaltphasen und Ausschaltphasen umfasst;
   die Steuereinheit (120) eine Abtastschaltung (122) umfasst, die so konfiguriert ist, dass sie einen Heizwiderstandswert der Zerstäubungseinheit in jeder Ausschaltphase während eines voreingestellten Zeitzyklus erfasst, und dass sie den Heizwiderstandswert an den Mikroprozessor (121) sendet; und
   der Mikroprozessor (121) so konfiguriert ist, dass er:

   eine Ausgangsspannung einer Stromversorgung der elektronischen Zerstäubungsvorrichtung in jeder Einschaltphase während des voreingestellten Zeitzyklus erfasst, und ein Tastverhältnis des PWM-Zyklus entsprechend einer jeweiligen Ausgangsspannung und eines jeweiligen Heizwiderstandswerts während des voreingestellten Zeitzyklus erfasst;
   eine Vielzahl von effektiven Ausgangsleistungen während des voreingestellten Zeitzyklus entsprechend jeder Ausgangsspannung, jedem Heizwiderstandswert und dem entsprechenden Tastverhältnis berechnet; und
   die Zerstäubungseinheit so steuert, dass sie die reduzierte Leistung abgibt oder das Heizen stoppt, wenn jede effektive Ausgangsleistung kleiner als ein voreingestellter Leistungsschwellenwert ist.

2. Elektronische Zerstäubungsvorrichtung nach Anspruch 1, wobei die Abtastschaltung (122) so konfiguriert ist, dass sie einen Echtzeitwiderstandswert der Zerstäubungseinheit (110) erfasst und den Echtzeitwiderstandswert an den Mikroprozessor (121) sendet, und
   wobei der Mikroprozessor (121) ferner so konfiguriert ist, dass er eine Echtzeittemperatur der Zerstäubungseinheit (110) gemäß dem Echtzeitwiderstandswert bestimmt und das PWM-Steuersignal gemäß einer Differenz zwischen der Echtzeittemperatur und der Zieltemperatur einstellt, um die Echtzeittemperatur der Zerstäubungseinheit so einzustellen, dass die Zieltemperatur erhalten wird.

3. Elektronische Zerstäubungsvorrichtung nach Anspruch 2, die ferner eine Eingabeaufforderungseinheit (130) umfasst, die so konfiguriert ist, dass sie eine Benutzeraufforderung bereitstellt, die geeignet ist, einen Benutzer darauf hinzuweisen, dass die Zerstäubungseinheit (110) einen anormalen Flüssigkeitsgehalt aufweist,
   wobei der Mikroprozessor (121) ferner so konfiguriert ist, dass er als Reaktion auf die Feststellung, dass die Zerstäubungseinheit (110) den anormalen Flüssigkeitsgehalt aufweist, die Benutzeraufforderung erzeugt.

4. Elektronische Zerstäubungsvorrichtung nach Anspruch 3, wobei die Eingabeaufforderungseinheit (130) einen Bildschirm und/oder eine Sprachaufforderung umfasst.

5. Elektronische Zerstäubungsvorrichtung nach Anspruch 2, wobei:

   die Abtastschaltung (122) umfasst: einen MOS-Transistor Q1, eine Diode D1, einen Widerstand R1 und einen Widerstand R2;
   der MOS-Transistor Q1 ein Gate aufweist, das elektrisch mit einem ADC-Abtastanschluss des Mikroprozessors verbunden ist, einen Drain, der elektrisch mit einem ersten Ende des Widerstands R1 verbunden ist, und eine Source, die elektrisch mit einer Stromversorgung verbunden ist;

ein zweites Ende des Widerstands R1 elektrisch mit einer Kathode der Diode D1 verbunden ist, und eine Anode der Diode D1 geerdet ist;

die Kathode der Diode D1 weiterhin elektrisch mit einem Ausgangsanschluss des Mikroprozessors verbunden ist, der Ausgangsanschluss des Mikroprozessors weiterhin elektrisch mit einem ersten Ende der Zerstäubungseinheit verbunden ist und ein zweites Ende der Zerstäubungseinheit geerdet ist; und

der Widerstand R2 ein erstes Ende, das elektrisch mit dem Gate des MOS-Transistors Q1 verbunden ist, und ein zweites Ende aufweist, das elektrisch mit der Source des MOS-Transistors Q1 verbunden ist.

6. Verfahren zur Heizungssteuerung, das auf eine elektronische Zerstäubungsvorrichtung angewendet wird, wobei die elektronische Zerstäubungsvorrichtung eine Zerstäubungseinheit (110), die so konfiguriert ist, dass sie Flüssigkeit in der elektronischen Zerstäubungsvorrichtung erhitzt, um die Flüssigkeit zu zerstäuben, und eine Steuereinheit (120) umfasst, wobei die Steuereinheit (120) das Verfahren zur Heizungssteuerung ausführt, wobei das Verfahren zur Heizungssteuerung umfasst:

Senden eines PWM-Steuersignals an die Zerstäubungseinheit, wobei das PWM-Steuersignal so konfiguriert ist, dass es die Zerstäubungseinheit so steuert, dass sie bei einer konstanten Temperatur heizt, die auf einer Zieltemperatur gehalten wird;

Berechnen einer effektiven Ausgangsleistung der Zerstäubungseinheit;

entsprechend der effektiven Ausgangsleistung Feststellen, ob ein Flüssigkeitsgehalt der Zerstäubungseinheit anormal ist; und

Steuern der Zerstäubungseinheit, um eine reduzierte Leistung abzugeben oder das Heizen zu stoppen, wenn festgestellt wird, dass der Flüssigkeitsgehalt der Zerstäubungseinheit anormal ist;

**dadurch gekennzeichnet, dass**

jeder PWM-Zyklus des PWM-Steuersignals eine Vielzahl von Einschaltphasen und Ausschaltphasen umfasst, und das Berechnen der effektiven Ausgangsleistung der Zerstäubungseinheit umfasst:

Erfassen einer Ausgangsspannung einer Stromversorgung der elektronischen Zerstäubungsvorrichtung in jeder Einschaltphase während eines voreingestellten Zeitzyklus;

Erfassen eines Heizwiderstandswerts der Zerstäubungseinheit in jeder Ausschaltphase während des voreingestellten Zeitzyklus;

Erfassen eines Tastverhältnisses des PWM-Zyklus entsprechend jeder Ausgangsspannung und jedem Heizwiderstandwert während der Zeitperiode; und

Berechnen einer Vielzahl von effektiven Ausgangsleistungen während der Zeitperiode entsprechend jeder Ausgangsspannung, jedem Heizwiderstandwert und einem entsprechenden Tastverhältnis.

7. Verfahren zur Heizungssteuerung nach Anspruch 6, wobei die Feststellung, ob der Flüssigkeitsgehalt der Zerstäubungseinheit entsprechend der effektiven Ausgangsleistung anormal ist, umfasst:

Feststellen, dass der Flüssigkeitsgehalt der Zerstäubungseinheit anormal ist, wenn jede effektive Ausgangsleistung geringer ist als ein voreingestellter Leistungsschwellenwert.

8. Verfahren zur Heizungssteuerung nach Anspruch 7, wobei die elektronische Zerstäubungsvorrichtung ferner eine Eingabeaufforderungseinheit umfasst, und das Verfahren ferner umfasst:

Erzeugen von Aufforderungsinformationen, die geeignet sind, den Benutzer darauf hinzuweisen, dass der Flüssigkeitsgehalt der Zerstäubungseinheit anormal ist, wenn jede effektive Ausgangsleistung geringer als der Leistungsschwellenwert ist; und

Senden der Aufforderungsinformationen an die Eingabeaufforderungseinheit zur Präsentation.

9. Verfahren zur Heizungssteuerung nach Anspruch 6, wobei das Steuern der Zerstäubungseinheit zum Heizen bei einer konstanten Temperatur, die auf der Zieltemperatur gehalten wird, umfasst:

Erfassen einer Echtzeittemperatur der Zerstäubungseinheit; und

Einstellen der Echtzeittemperatur der Zerstäubungseinheit entsprechend der Zieltemperatur.

10. Verfahren zur Heizungssteuerung nach Anspruch 9, wobei das Einstellen der Echtzeittemperatur der Zerstäubungseinheit entsprechend der Zieltemperatur umfasst:

Erfassen eines Anfangswiderstandswerts und einer Anfangstemperatur der Zerstäubungseinheit in einem unbeheizten Zustand;

Berechnen eines Zielwiderstandswerts der Zerstäubungseinheit beim Aufheizen auf die Zieltemperatur gemäß dem Anfangswiderstandswert, der Anfangstemperatur, dem Temperaturkoeffizienten des Widerstands und der voreingestellten Zieltemperatur der Zerstäubungseinheit;

Erfassen eines Heizwiderstandswerts durch ein ADC-Abtastverfahren; und

Einstellen des PWM-Steuersignals mittels eines PID-Algorithmus, um die Echtzeittemperatur der Zerstäubungseinheit einzustellen, wenn ein Absolutwert einer Differenz zwischen dem Heizwiderstandswert und dem Zielwiderstandswert größer als eine untere Grenze eines voreingestellten Differenzbereichs und kleiner als eine obere Grenze des Differenzbereichs ist.

11. Verfahren zur Heizungssteuerung nach Anspruch 10, wobei das Einstellen der Echtzeittemperatur der Zerstäubungseinheit entsprechend der Zieltemperatur umfasst:
Steuern der Zerstäubungseinheit, um mit der maximalen Ausgangsleistung zu heizen, wenn der Absolutwert der Differenz zwischen dem Heizwiderstandswert und dem Zielwiderstandswert kleiner als die untere Grenze des Differenzbereichs ist.

12. Verfahren zur Heizungssteuerung nach Anspruch 10, wobei das Erfassen eines Anfangswiderstandswerts der Zerstäubungseinheit in einem unbeheizten Zustand umfasst:

Abtasten des Widerstandswerts der Zerstäubungseinheit mit einer voreingestellten Abtastfrequenz als Reaktion auf das Erkennen des Ladens der Patrone;

Vergleichen der erfassten Widerstandswerte;

Bestimmen der Widerstandswerte als den Anfangswiderstandswert der Zerstäubungseinheit im unbeheizten Zustand, wenn die Widerstandswerte alle gleich sind; Aktualisieren der Aufzeichnung des Anfangswiderstandswerts; und

Erfassen des in der letzten Zeitspanne ermittelten Anfangswiderstandswerts aus der Anfangswiderstandswertaufzeichnung als den Anfangswiderstandswert der Zerstäubungseinheit im unbeheizten Zustand, wenn sich die erfassten Widerstandswerte mit der Erfassungszeitspanne ändern.

13. Computerprogrammprodukt, das umfasst:

ein maschinenlesbares Medium; und
Programmanweisungen, die in dem maschinenlesbaren Medium enthalten sind, wobei die Programmanweisungen ein Verfahren zur Heizungssteuerung nach einem der Ansprüche 6 bis 12 definieren.

## Revendications

1. Dispositif d'atomisation électronique, comprenant :

une unité d'atomisation (110) configurée pour chauffer un liquide dans le dispositif d'atomisation électronique afin d'atomiser le liquide ; et
une unité de commande (120) comprenant un microprocesseur (121) configuré pour envoyer un signal de commande PWM à l'unité d'atomisation, et le signal de commande PWM est configuré pour commander l'unité d'atomisation afin qu'elle chauffe à une température constante maintenue à une température cible ;
dans lequel l'unité de commande (120) est configurée pour :

calculer une puissance de sortie effective de l'unité d'atomisation ;
déterminer si le contenu liquide de l'unité d'atomisation est anormal en fonction de la puissance de sortie effective ; et
commander l'unité d'atomisation afin qu'elle délivre une puissance réduite ou arrête de chauffer lorsqu'il est déterminé que le contenu liquide de l'unité d'atomisation est anormal ;
le dispositif d'atomisation électronique étant **caractérisé en ce que**
chaque cycle PWM du signal de commande PWM comprend une pluralité de phases d'activation et de phases de désactivation ;
l'unité de commande (120) comprend un circuit d'échantillonnage (122) configuré pour acquérir une résistance de chauffage de l'unité d'atomisation dans chaque phase de désactivation pendant un cycle de temps prédéfini ; et envoyer la résistance de chauffage au microprocesseur (121) ; et
le microprocesseur (121) est configuré pour :

acquérir une tension de sortie d'une alimentation électrique du dispositif d'atomisation électronique dans chaque phase d'activation pendant le cycle de temps prédéfini, et acquérir un rapport cyclique du cycle PWM correspondant à une tension de sortie et une résistance de chauffage respectives pendant le cycle de temps prédéfini ;
calculer une pluralité de puissances de sortie effectives pendant le cycle de temps prédéfini en fonction de chaque tension de sortie, de chaque résistance de chauffage et du rapport cyclique correspondant ; et

commander l'unité d'atomisation afin qu'elle délivre la puissance réduite ou arrête de chauffer si chaque puissance de sortie effective est inférieure à un seuil de puissance prédéfini.

2. Dispositif d'atomisation électronique selon la revendication 1, dans lequel le circuit d'échantillonnage (122) est configuré pour acquérir une résistance en temps réel de l'unité d'atomisation (110) et envoyer la résistance en temps réel au microprocesseur (121), et

dans lequel le microprocesseur (121) est en outre configuré pour déterminer une température en temps réel de l'unité d'atomisation (110) en fonction de la résistance en temps réel, et ajuster le signal de commande PWM en fonction d'une différence entre la température en temps réel et la température cible pour ajuster la température en temps réel de l'unité d'atomisation afin d'obtenir la température cible.

3. Dispositif d'atomisation électronique selon la revendication 2, comprenant en outre une unité d'invite (130) configurée pour fournir une invite utilisateur adaptée à indiquer à un utilisateur que l'unité d'atomisation (110) présente un contenu liquide anormal, dans lequel le microprocesseur (121) est en outre configuré pour générer l'invite utilisateur en réponse à la détermination du fait que l'unité d'atomisation (110) présente un contenu liquide anormal.

4. Dispositif d'atomisation électronique selon la revendication 3, dans lequel l'unité d'invite (130) comprend au moins un écran d'affichage et un indicateur vocal.

5. Dispositif d'atomisation électronique selon la revendication 2, dans lequel :

le circuit d'échantillonnage (122) comprend : un transistor MOS Q1, une diode D1, une résistance R1 et une résistance R2 ;

le transistor MOS Q1 a une grille connectée électriquement à une borne d'échantillonnage ADC du microprocesseur, un drain connecté électriquement à une première extrémité de la résistance R1 et une source connectée électriquement à une alimentation électrique ;

une seconde extrémité de la résistance R1 est connectée électriquement à une cathode de la diode D1 et une anode de la diode D1 est mise à la terre ;

la cathode de la diode D1 est en outre connectée électriquement à une borne de sortie du microprocesseur, la borne de sortie du microprocesseur est en outre connectée électriquement à une première extrémité de l'unité d'atomisation et une seconde extrémité de l'unité d'atomisation est mise à la terre ; et

la résistance R2 a une première extrémité connectée électriquement à la grille du transistor MOS Q1 et une seconde extrémité connectée électriquement à la source du transistor MOS Q1.

6. Procédé de commande de chauffage appliqué à un dispositif d'atomisation électronique, le dispositif d'atomisation électronique comprenant une unité d'atomisation (110) configurée pour chauffer un liquide dans le dispositif d'atomisation électronique afin d'atomiser le liquide, et une unité de commande (120), l'unité de commande (120) exécutant le procédé de commande de chauffage, le procédé de commande de chauffage comprenant les étapes consistant à :

envoyer un signal de commande PWM à l'unité d'atomisation, dans lequel le signal de commande PWM est configuré pour commander l'unité d'atomisation afin qu'elle chauffe à une température constante maintenue à une température cible ;

calculer une puissance de sortie effective de l'unité d'atomisation ;

déterminer si le contenu liquide de l'unité d'atomisation est anormal en fonction de la puissance de sortie effective ; et

commander l'unité d'atomisation afin qu'elle délivre une puissance réduite ou arrête de chauffer lorsqu'il est déterminé que le contenu liquide de l'unité d'atomisation est anormal ;

**caractérisé en ce que**

chaque cycle PWM du signal de commande PWM comprend une pluralité de phases d'activation et de phases de désactivation, et l'étape consistant à calculer la puissance de sortie effective de l'unité d'atomisation comprend les étapes consistant à :

acquérir une tension de sortie d'une alimentation électrique du dispositif d'atomisation électronique dans chaque phase d'activation pendant un cycle de temps prédéfini ;

acquérir une résistance de chauffage de l'unité d'atomisation dans chaque phase de désactivation pendant le cycle de temps prédéfini ;

acquérir un rapport cyclique du cycle PWM correspondant à chaque tension de sortie et résistance de chauffage pendant la période de temps ; et

calculer une pluralité de puissances de sortie effectives pendant la période de temps en fonction de chaque tension de sortie, de chaque résistance de chauffage et d'un rapport cyclique correspondant.

**7.** Procédé de commande de chauffage selon la revendication 6, dans lequel l'étape consistant à déterminer que le contenu liquide de l'unité d'atomisation est anormal en fonction de la puissance de sortie effective comprend l'étape consistant à :
déterminer que le contenu liquide de l'unité d'atomisation est anormal si chaque puissance de sortie effective est inférieure à un seuil de puissance prédéfini.

**8.** Procédé de commande de chauffage selon la revendication 7, dans lequel le dispositif d'atomisation électronique comprend en outre une unité d'invite, et le procédé comprend en outre les étapes consistant à :

générer des informations d'invite adaptées à indiquer à l'utilisateur que le contenu liquide de l'unité d'atomisation est anormal si chaque puissance de sortie effective est inférieure au seuil de puissance ; et
envoyer les informations d'invite à l'unité d'invite pour présentation.

**9.** Procédé de commande de chauffage selon la revendication 6, dans lequel l'étape consistant à commander l'unité d'atomisation afin qu'elle chauffe à une température constante maintenue à la température cible comprend les étapes consistant à :

acquérir une température en temps réel de l'unité d'atomisation ; et
ajuster la température en temps réel de l'unité d'atomisation en fonction de la température cible.

**10.** Procédé de commande de chauffage selon la revendication 9, dans lequel l'étape consistant à ajuster la température en temps réel de l'unité d'atomisation en fonction de la température cible comprend les étapes consistant à :

acquérir une résistance initiale et une température initiale de l'unité d'atomisation dans un état non chauffé ;
calculer une résistance cible de l'unité d'atomisation lors du chauffage à la température cible en fonction de la résistance initiale, de la température initiale, du coefficient de température de la résistance et de la température cible prédéfinie de l'unité d'atomisation ;
acquérir une résistance de chauffage par un procédé d'échantillonnage ADC ; et
ajuster le signal de commande PWM au moyen d'un algorithme PID pour ajuster la température en temps réel de l'unité d'atomisation lorsqu'une valeur absolue d'une différence entre la résistance de chauffage et la résistance cible est supérieure à une limite inférieure d'une plage de différence prédéfinie et inférieure à une limite supérieure de la plage de différence.

**11.** Procédé de commande de chauffage selon la revendication 10, dans lequel l'étape consistant à ajuster la température en temps réel de l'unité d'atomisation en fonction de la température cible comprend l'étape consistant à :
commander l'unité d'atomisation afin qu'elle chauffe à la puissance de sortie maximale lorsque la valeur absolue de la différence entre la résistance de chauffage et la résistance cible est inférieure à la limite inférieure de la plage de différence.

**12.** Procédé de commande de chauffage selon la revendication 10, dans lequel l'étape consistant à acquérir une résistance initiale de l'unité d'atomisation dans un état non chauffé comprend les étapes consistant à :

échantillonner la résistance de l'unité d'atomisation à une fréquence d'échantillonnage prédéfinie en réponse à l'identification du chargement de la cartouche ;
comparer les résistances acquises ;
déterminer les résistances comme étant la résistance initiale de l'unité d'atomisation dans l'état non chauffé si les résistances sont toutes égales ;
mettre à jour l'enregistrement de la résistance initiale ; et
acquérir la résistance initiale déterminée en dernier lieu à partir de l'enregistrement de la résistance initiale comme étant la résistance initiale de l'unité d'atomisation dans l'état non chauffé si les résistances acquises changent avec le temps d'acquisition.

**13.** Produit programme d'ordinateur comprenant :

un support lisible par machine ; et
des instructions de programme contenues dans le support lisible par machine, les instructions de programme spécifiant un procédé de commande de chauffage selon l'une quelconque des revendications 6 à 12.

110    120

Atomization
Unit

Control Unit

FIG. 1

FIG. 2

FIG. 3

**EP 3 771 351 B1**

FIG. 4

**19**

S210

The atomization unit 110 is controlled to heat with a constant output of a preset power for a preset period of time in response to receiving a start-up instruction to start

S220

Whether the atomization unit 110 has a normal liquid content is determined according to a variation in a resistance of the atomization unit 110 after heating

S230

The atomization unit 110 is controlled to heat to a preset target temperature in response to receiving a suction and heating instruction, if the atomization unit has the normal liquid content

S240

Whether the atomization unit has the normal liquid content is detected according to a preset time cycle

S250

The atomization unit 110 is controlled to stop heating if the atomization unit has abnormal liquid content

FIG. 5

Device For Heating Control 300

/ 310

Preheating Control Module

/ 320

Liquid Content Pre-Detection Module

/ 330

Atomization Heating Control Module

/ 340

Suction Phase Liquid Content Detection Module

/ 350

Heating Stop Control Module

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2019106962440
- US 2014020693 A1
- WO 2017185355 A1
- WO 2016112541 A1
- CN 108363432 A
- CN 109007985 A